# EUROPEAN PATENT SPECIFICATION

(11) **EP 2 980 859 B1**
(45) Date of publication and mention of the grant of the patent: **08.01.2020**
(21) Application number: 14775423.8
(22) Date of filing: 09.01.2014
(51) Int. Cl.: H01L 31/049, H01L 31/02, H01L 31/056, H01L 31/05, H01L 31/048, B32B 17/10, H01L 31/042

(54) **SOLAR CELL MODULE**
SOLARZELLENMODUL
MODULE DE CELLULES SOLAIRES

(30) Priority: 26.03.2013 JP 2013063974
(43) Date of publication of application: 03.02.2016
(73) Proprietor: Panasonic Intellectual Property Management Co., Ltd., Osaka-shi, Osaka 540-6207 (JP)
(72) Inventor: IMADA, Naoto, Moriguchi City Osaka 570-8677 (JP)
(74) Representative: Glawe, Delfs, Moll
(86) International application number: PCT/JP2014/050208
(87) International publication number: WO 2014/156213

(56) References cited:
- EP-A2- 2 725 628
- WO-A1-95/15582
- WO-A1-2007/073203
- CN-A- 102 800 730
- JP-A- 2003 234 484
- JP-A- 2011 187 555
- JP-A- 2011 187 555
- JP-A- 2011 222 811
- JP-A- 2012 089 577
- JP-A- 2012 119 668
- US-B1- 6 175 075

## Description

### TECHNICAL FIELD

The invention relates to a solar cell module.

### BACKGROUND ART

A solar cell module is formed by disposing solar cells in a lengthwise direction and a widthwise direction and electrically connecting the solar cells to each other. For such a solar cell module, a technique is proposed which involves providing a reflective filler member on the back surface sides of the solar cells so that light being incident from the light receiving sides of the solar cells and passing between the solar cells can be reflected toward the light receiving sides and caused to be incident again on the solar cells (Patent Document 1).

### PRIOR ART DOCUMENT

### PATENT DOCUMENT

Patent Document 1: Japanese Patent Application Publication No. 2006-36874 A solar cell module according to the preamble of claim 1 is disclosed in JP 2011 187 555 A; similar arrangements are disclosed in JP 2003 234 484 A, EP 2 725 628 A2, WO 95 155 82 A1, WO 2007 07 32 03 A1 and CN 102 800 730 A.

### SUMMARY OF THE INVENTION

### PROBLEM OF BE SOLVED BY THE INVENTION

In recent years, there has been a demand to further improve the output characteristics of solar cell modules.

It is an object of the invention to provide a solar cell module capable of causing light reflected on its reflection member to be efficiently incident on the solar cells to thereby improve the output characteristics.

### MEANS FOR SOLVING THE PROBLEM

This object is achieved by a solar cell module as defined in claim 1; the dependent claims are related to further developments of the invention.

### EFFECT OF THE INVENTION

According to the invention, light reflected on a reflection member can be caused to be efficiently incident on solar cells, and the output characteristics can therefore be improved.

### BRIEF DESCRIPTION OF THE DRAWINGS

[Fig. 1] Fig. 1 is a schematic plan view illustrating a solar cell module of one embodiment of the invention.
[Fig. 2] Fig. 2 is a schematic cross-sectional view taken along line A-A illustrated in Fig. 1.
[Fig. 3] Fig. 3 is a schematic cross-sectional view for explaining a tab wiring member connecting solar cells in the solar cell module of the one embodiment of the invention.
[Fig. 4] Fig. 4 is an enlarged schematic plan view of interconnection wiring members and solar cells in the solar cell module of the one embodiment of the invention.
[Fig. 5] Fig. 5 is a schematic plan view illustrating re-incidence areas on a solar cell.
[Fig. 6] Fig. 6 is a schematic cross-sectional view for explaining reflection of incident light passing between solar cells in the solar cell module.
[Fig. 7] Fig. 7 is a schematic cross-sectional view illustrating a reflective filler member between solar cells in the solar cell module.
[Fig. 8] Fig. 8 is a schematic cross-sectional view illustrating the reflective filler member between solar cell strings in the solar cell module.

### MODES FOR CARRYING OUT THE INVENTION

A preferred embodiment of the invention is described below. It is to be noted that the following embodiment is a mere example, and the invention is not limited to the following embodiment. Moreover, in the drawings, members with substantially the same function may be referred to by the same reference numeral.

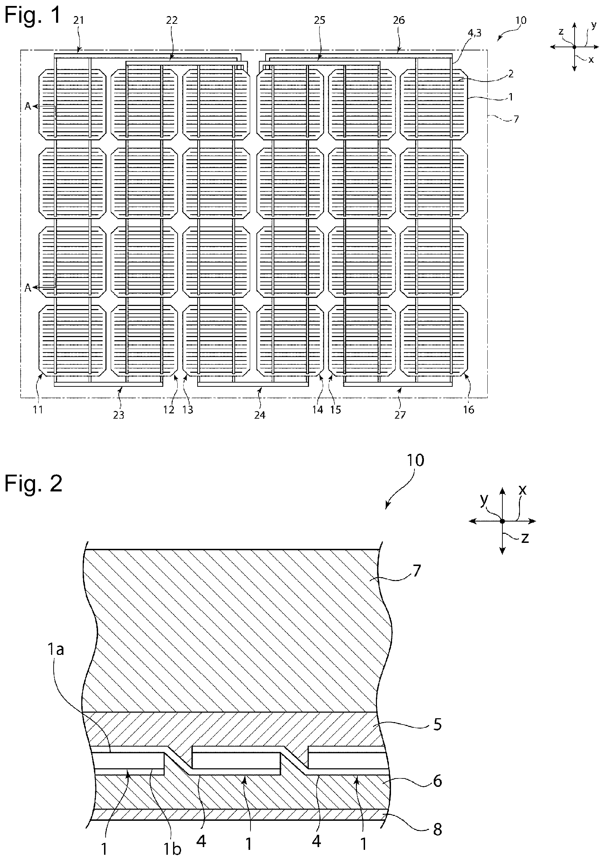

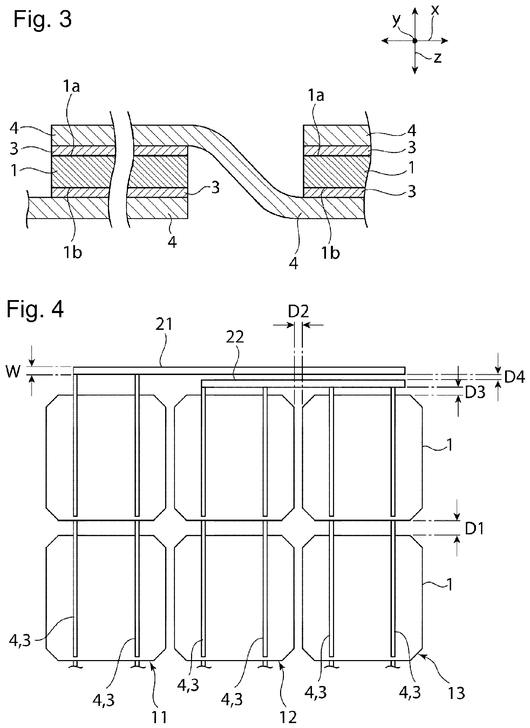

Fig. 1 is a schematic plan view illustrating a solar cell module of one embodiment of the invention. Fig. 2 is a schematic cross-sectional view taken along line A-A illustrated in Fig. 1. Fig. 3 is a schematic cross-sectional view for explaining a tab wiring member connecting solar cells in the solar cell module of the one embodiment of the invention.

As illustrated in Fig. 1, solar cell module 10 includes solar cell strings 11 to 16 arranged side by side a widthwise direction (y direction) . Solar cell strings 11 to 16 are each formed by electrically connecting solar cells 1 arranged side by side in a lengthwise direction (x direction) . Note that in the invention, the "lengthwise direction" refers to the direction in which solar cells 1 are arranged side by side in solar cell strings 11 to 16. Moreover, the "widthwise direction" is the direction in which solar cell strings 11 to 16 are arranged side by side and is a direction substantially perpendicular to the lengthwise direction.

As illustrated in Fig. 2, in each of solar cell strings 11 to 16, neighboring solar cells 1 are connected by tab wiring members 4. Tab wiring members 4 are connected at one end to a front surface 1a side of one of neighboring solar cells 1 and connected at the other end to a back surface 1b side of the other of neighboring solar cells 1. As illustrated in Fig. 1, many finger electrodes 2 extending in the widthwise direction are formed on front surface 1a of each solar cell 1. Busbar electrodes 3 extending substantially perpendicularly to these finger electrodes 2 are provided to be electrically connected to finger electrodes 2. Moreover, though not illustrated, finger electrodes 2 and busbar electrodes 3 are formed on back surface 1b of each solar cell 1 similarly to front surface 1a. Note that finger electrodes 2 formed on back surface 1b are formed more densely than those on front surface 1a. Finger electrodes 2 and busbar electrodes 3 formed on back surface 1b form back electrodes of solar cell 1.

In Fig. 1, busbar electrodes 3 on front surface 1a are illustrated overlapping tab wiring members 4. Thus, busbar electrodes 3 on front surface 1a are provided to extend in the lengthwise direction of solar cell 1. Note that in the invention, "extending in the lengthwise direction" is not limited to extending in a straight form parallel with the lengthwise direction, but also includes, for example, extending in a zigzag form with straight lines which are not parallel with the lengthwise direction and are connected to each other.

As illustrated in Fig. 3, tab wiring members 4 provided between neighboring solar cells 1 connect busbar electrodes 3 on the front surface 1a side of one of solar cells 1 and busbar electrodes 3 on the back surface 1b side of the other of solar cells 1. Thus, busbar electrodes 3 on the front surface 1a side of each solar cell 1 are electrically connected to busbar electrodes 3 of its neighboring solar cell 1 which are back surface electrodes thereof by tab wiring members 4 which are wiring members. Busbar electrodes 3 and tab wiring members 4 are connected, for example, by solder or resin adhesive, which is not illustrated.

As illustrated in Fig. 1, tab wiring members 4 provided on the front surface 1a side of uppermost solar cell 1 of solar cell string 11 are connected to first interconnection wiring member 21. Tab wiring members 4 provided on the back surface 1b side of lowermost solar cell 1 of solar cell string 11 are connected to third interconnection wiring member 23. Tab wiring members 4 provided on the front surface 1a side of uppermost solar cell 1 of solar cell string 12 are connected to second interconnection wiring member 22. Tab wiring members 4 provided on the back surface 1b side of lowermost solar cell 1 of solar cell string 12 are connected to third interconnection wiring member 23. Tab wiring members 4 provided on the front surface 1a side of uppermost solar cell 1 of solar cell string 13 are connected to second interconnection wiring member 22. Tab wiring members 4 provided on the back surface 1b side of lowermost solar cell 1 of solar cell string 13 are connected to third interconnection wiring member 24.

Tab wiring members 4 provided on the front surface 1a side of uppermost solar cell 1 of solar cell string 14 are connected to second interconnection wiring member 25. Tab wiring members 4 provided on the back surface 1b side of lowermost solar cell 1 of solar cell string 14 are connected to third interconnection wiring member 24. Tab wiring members 4 provided on the front surface 1a side of uppermost solar cell 1 of solar cell string 15 are connected to second interconnection wiring member 25. Tab wiring members 4 provided on the back surface 1b side of lowermost solar cell 1 of solar cell string 15 are connected to third interconnection wiring member 27. Tab wiring members 4 provided on the front surface 1a side of uppermost solar cell 1 of solar cell string 16 are connected to first interconnection wiring member 26. Tab wiring members 4 provided on the back surface 1b side of lowermost solar cell 1 of solar cell string 16 are connected to third interconnection wiring member 27.

Solar cell strings 11 to 16 are electrically connected to each other in series or parallel by being connected to given ones of first interconnection wiring members 21 and 26, second interconnection wiring members 22 and 25, and third interconnection wiring members 23, 24, and 27 as described above.

As illustrated in Fig. 2, front surface member 7 is provided on the front surface 1a side of solar cells 1 which is the light receiving side. Front surface member 7 can be made from glass, for example. Back surface member 8 is provided on the back surface 1b side of solar cells 1. Back surface member 8 can be made from resin, for example. Back surface member 8 may also be made from a resin sheet provided therein with a metal layer formed of aluminum or the like.

Light-receiving-side filler member 5 is provided between front surface member 7 and solar cells 1. Reflective filler member 6 is provided between back surface member 8 and solar cells 1. Light-receiving-side filler member 5 can be formed of resin, for example, and reflective filler member 6 is formed of resin. As such resin, non-crosslinkable resin formed of polyethylene or polypropylene, ethylene-vinyl acetate copolymer (EVA), crosslinkable resin made of polyethylene or polypropylene, and the like are available. Reflective filler member 6 is a member configured to reflect incident light from the light receiving side back toward the light receiving side again. For reflective filler member 6, resin can be used to which white pigment such as titanium oxide, for example, is added and a certain light reflective power is therefore given, such that it is capable of reflecting light obtained from the light receiving side back toward the light receiving side again.

Fig. 4 is an enlarged schematic plan view of some interconnection wiring members and solar cells in the solar cell module of the one embodiment of the invention. As illustrated in Fig. 4, in this embodiment, distance D1 between solar cells 1 in each of solar cell strings 11, 12, and 13 is larger than distance D2 between the solar cell strings. Distance D1 is preferably 1.1 times distance D2 or larger, and more preferably between 1.3 and 5 times distance D2, both inclusive. In Fig. 4, the distance between solar cell strings 12 and 13 is illustrated as D2; likewise, the distance between solar cell strings 11 and 12 is also D2.

By making distance D1 between solar cells 1 in each of the solar cell strings larger than distance D2 between the solar cell strings, the output characteristics can be improved. The reason for this is described below.

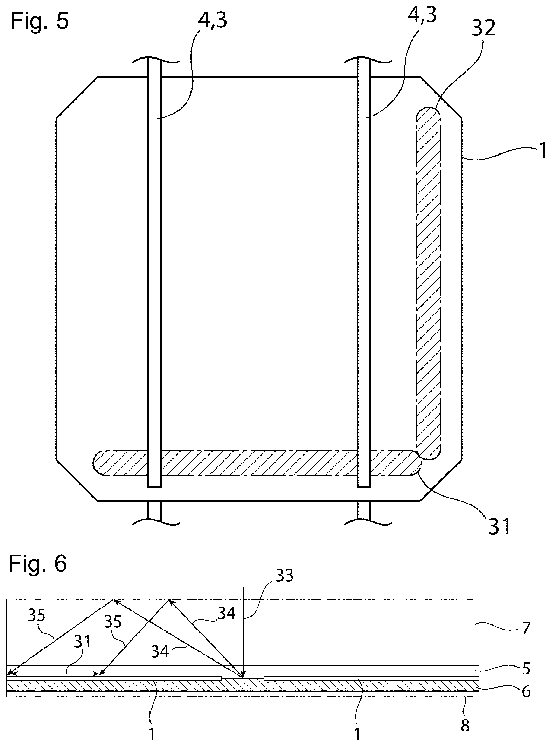

Fig. 6 is a schematic cross-sectional view for explaining reflection of incident light passing between solar cells in the solar cell module. As illustrated in Fig. 6, incident light 33 passing between solar cells 1 is reflected on reflective filler member 6 and becomes reflected light 34. Reflected light 34 is reflected at the interface of front surface member 7 and the outside and is incident again on solar cells 1 as re-incident light 35.

Fig. 5 is a schematic plan view illustrating re-incidence areas on a solar cell. Part of incident light passing between solar cells in a solar cell string section is then caused to be incident on re-incidence area 31. On the other hand, part of incident light passing between solar cells of different solar cell strings is then caused to be incident on re-incidence area 32. As illustrated in Fig. 5, re-incidence area 32 is located far from busbar electrodes 3, so that carriers generated by re-incident light on re-incidence area 32 cannot be efficiently collected. On the other hand, re-incidence area 31 is located near busbar electrodes 3, so that the resistive loss during carrier collection is small and carriers generated by re-incident light on re-incidence area 31 can be efficiently collected. In this embodiment, since distance D1 between solar cells 1 in each of the solar cell strings is set larger than distance D2 between the solar cell strings as mentioned above, the amount of re-incident light on re-incidence area 31 can be made larger than that on re-incidence area 32. Accordingly, carriers generated by re-incident light can be efficiently collected, and the output characteristics can therefore be improved.

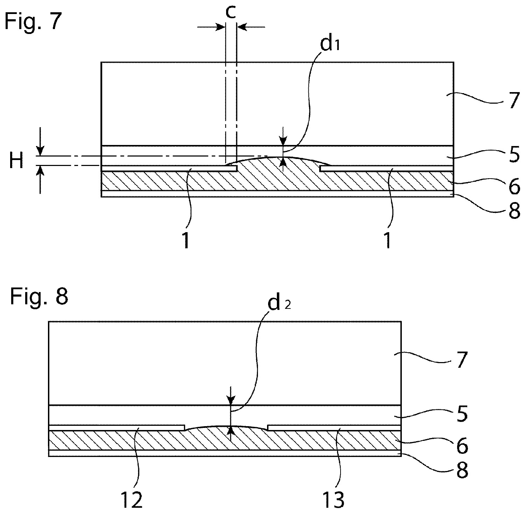

Fig. 7 is a schematic cross-sectional view illustrating the reflective filler member between solar cells in the solar cell module. Fig. 8 is a schematic cross-sectional view illustrating the reflective filler member between solar cell strings in the solar cell module. As illustrated in Figs. 7 and 8, in this embodiment, the height of reflective filler member 6 between solar cells 1 in each of the solar cell strings is larger than the height of reflective filler member 6 between solar cells 1 of solar cell strings 12 and 13. Specifically, as illustrated in Fig. 7, reflective filler member 6 between solar cells 1 in each of the solar cell strings is formed to protrude by height H from solar cells 1. On the other hand, as illustrated in Fig. 8, reflective filler member 6 between solar cell strings 12 and 13 is formed not to protrude upward from solar cells 1. Thus, distance d₁ between reflective filler member 6 and front surface member 7 between solar cells 1 illustrated in Fig. 7 is smaller than distance d₂ between reflective filler member 6 and front surface member 7 between solar cell strings 12 and 13 illustrated in Fig. 8. To put it differently, the thickness of light-receiving-side filler member 5 between solar cells 1 is smaller than the thickness of light-receiving-side filler member 5 between solar cell strings 12 and 13. In this way, the amount of light absorbed by light-receiving-side filler member 5 between solar cells 1 can be made smaller than the amount of light absorbed by light-receiving-side filler member 5 between solar cell strings 12 and 13.

Thus, the reflection of incident light on reflective filler member 6 between solar cells 1 can be made greater than the reflection of incident light on reflective filler member 6 between solar cell strings 12 and 13. Accordingly, the amount of re-incident light on re-incidence area 31 illustrated in Fig. 5 can be made larger than that on re-incidence area 32. This makes it possible to efficiently collect carriers generated by re-incident light and therefore improve the output characteristics.

Moreover, in this embodiment, as illustrated in Fig. 7, reflective filler member 6 is provided between solar cells 1 in each of the solar cell strings in such a way as to cover peripheral portions of solar cells 1. Amount C covered by reflective filler member 6 is larger than the amount covered by reflective filler member 6 between solar cell strings 12 and 13 illustrated in Fig. 8. An invalid area where neither a pn junction nor pin junction is formed is present in the peripheral portion of each solar cell 1, and the ratio of utilization of incident light at the invalid area is low. Then, with reflective filler member 6 provided in such a way as to cover the peripheral portion of solar cell 1, the ratio of utilization of incident light at the invalid area can be increased. By making the amount C by which reflective filler member 6 between solar cells 1 in each of the solar cell strings covers the peripheral portion of each of these solar cells 1, larger than the amount covered by reflective filler member 6 between solar cell strings 12 and 13 as illustrated in Figs. 7 and 8, the amount of re-incident light on re-incidence area 31 illustrated in Fig. 5 can be increased. Accordingly, carriers generated by re-incident light can be efficiently collected, and the output characteristics can therefore be improved.

As illustrated in Fig. 4, distance D1 between solar cells 1 in each of the solar cell strings is larger than distance D3 between second interconnection wiring member 22 and solar cell 1. Light reflected after passing between second interconnection wiring member 22 and solar cell 1 is re-incident on solar cell 1 neighboring second interconnection wiring member 22, and only this re-incident light contributes to power generation. On the other hand, light reflected after passing between solar cells 1 in the solar cell string is re-incident on both of neighboring solar cells 1. Thus, the amount of light, which contributes to power generation, can be increased and the ratio of utilization of incident light can be improved.

As illustrated in Fig. 4, in this embodiment, as interconnection wiring members, first interconnection wiring member 21 and second interconnection wiring member 22 are provided side by side in the lengthwise direction. In this embodiment, as illustrated in Fig. 4, distance D1 between solar cells 1 in each of the solar cell strings is larger than distance D4 between first interconnection wiring member 21 and second interconnection wiring member 22. Light reflected after passing between first interconnection wiring member 21 and second interconnection wiring member 22 is re-incident on solar cell 1 neighboring second interconnection wiring member 22, and this re-incident light contributes to power generation. On the other hand, light reflected after passing between solar cells 1 in the solar cell string is re-incident on both of neighboring solar cells 1. Thus, the amount of light, which contributes to power generation, can be increased and the ratio of utilization of incident light can be improved.

As illustrated in Fig. 4, in this embodiment, second interconnection wiring member 22 is provided closer to the solar cell strings than first interconnection wiring member 21 is. In this embodiment, as illustrated in Fig. 4, distance D1 between solar cells 1 in each of the solar cell strings is larger than distance D3 between second interconnection wiring member 22 and the solar cell strings, and distance D3 between second interconnection wiring member 22 and the solar cell strings is larger than distance D4 between first interconnection wiring member 21 and second interconnection wiring member 22. The position between first interconnection wiring member 21 and second interconnection wiring member 22 is farther from solar cells 1 than is the position between second interconnection wiring member 22 and the solar cell strings. Thus, the ratio of utilization of light passing between first interconnection wiring member 21 and second interconnection wiring member 22 is lower than the ratio of utilization of light passing between second interconnection wiring member 22 and the solar cell strings. Then, by satisfying the relationship of distance D1 > distance D3 > distance D4, the ratio of utilization of light can be increased, and the output characteristics can therefore be improved.

As illustrated in Fig. 4, in this embodiment, distance D1 between solar cells 1 in each of the solar cell strings is larger than width W of first interconnection wiring member 21 in the lengthwise direction. Note that the width of second interconnection wiring member 22 in the lengthwise direction is equal to width W of first interconnection wiring member 21 in the lengthwise direction. First interconnection wiring member 21 and second interconnection wiring member 22 obstruct the incidence of light. Then, by narrowing widths W of first interconnection wiring member 21 and second interconnection wiring member 22 in the lengthwise direction and broadening distance D1 between solar cells 1 in each of the solar cell strings accordingly, the amount of re-incident light can be increased. As mentioned above, between solar cells 1 in the solar cell string is an area where the ratio of utilization of light can be most effectively increased by means of the reflection by reflective filler member 6. Thus, by broadening distance D1 between solar cells 1 in the solar cell string, the output characteristics can be efficiently improved.

### EXPLANATION OF THE REFERENCE NUMERALS

- 1: solar cell
- 1a: front surface
- 1b: back surface
- 2: finger electrode
- 3: busbar electrode
- 4: tab wiring member
- 5: light-receiving-side filler member
- 6: reflective filler member
- 7: front surface member
- 8: back surface member
- 10: solar cell module
- 11 to 16: solar cell string
- 21, 26: first interconnection wiring member
- 22, 25: second interconnection wiring member
- 23, 24, 27: third interconnection wiring member
- 31, 32: re-incidence area
- 33: incident light
- 34: reflected light
- 35: re-incident light

## Claims

1. A solar cell module, comprising:
solar cell strings (11-16) arranged side by side in a widthwise direction, each of the solar cell strings (11-16) including solar cells (1) arranged side by side in a lengthwise direction, and a tab wiring member (4) electrically connecting at least some of the solar cells (1) to each other;
an interconnection wiring member (21-27) electrically connecting at least some of the solar cell strings (11-16) to each other;
a front surface member (7);
a light-receiving-side filler member (5) filled between the front surface member (7) and the solar cell strings (11-16); and
a back surface member (8);
wherein each of the solar cells (1) includes on its front surface (1a) a busbar electrode (3) extending in the lengthwise direction, and
a distance (D1) between the solar cells (1) in each of the solar cell strings (11-16) is larger than a distance (D2) between the solar cell strings (11-16),
**characterized in that** a reflective filler member (6) formed of resin material is filled between the back surface member (8) and the solar cell strings (11-16), provided on back surface sides of the solar cell strings (11-16) and is in contact with the back surface (1b) of the solar cells (1) and provided between adjacent solar cells (1) in each of the solar cell strings (11-16) and between adjacent solar cell strings (11-16), wherein
a height of the reflective filler member between the solar cells (1) in each of the solar cell strings (11-16) is larger than a height of the reflective filler member between the solar cell strings (11-16), such that a distance (d₁) between the reflective filler member (6) and the front surface member (7) between solar cells (1) in each of the solar cell strings (11-16) is smaller than a distance (d₂) between the reflective filler member (6) and front surface member (7) between the solar cell strings (11-16),
wherein the reflective filler member (6) is provided between the solar cells (1) in each of the solar cell strings (11-16) in such a way as to cover peripheral portions of the front surface of each of the solar cells (1), and an amount (C) covered by the reflective filler member between the solar cells (1) in each of the solar cell strings (11-16) is larger than an amount covered by the reflective filler member between the solar cell strings (11-16).

2. The solar cell module according to claim 1, wherein the reflective filler member (6) further contains white pigment.

3. The solar cell module according to claim 1 or 2, wherein a first interconnection wiring member (21) and a second interconnection wiring member (22) are provided side by side in the length-wise direction, wherein the second interconnection wiring member (22) is provided closer to a corresponding solar cell string (12, 13) than the first interconnection wiring member (21) wherein the distance (D1) between the solar cells (1) in each of the solar cell strings (11-16) is larger than a distance (D3) between the second interconnection wiring member (22) and the corresponding solar cell strings (12, 13).

4. The solar cell module according to any one of claims 1 to 3, wherein
as the interconnection wiring member, a first interconnection wiring member (21, 22) and a second interconnection wiring member (22, 21) are provided side by side in the lengthwise direction, and
the distance (D1) between the solar cells (1) in each of the solar cell strings (11-16) is larger than a distance (D4) between the first interconnection wiring member (21, 22) and the second interconnection wiring member (22, 21).

5. The solar cell module according to claim 4, wherein
the second interconnection wiring member (22) is provided closer to the solar cell strings (11-16) than the first interconnection wiring member is,
the distance (D1) between the solar cells (1) in each of the solar cell strings (11-16) is larger than a distance (D3) between the second interconnection wiring member (22) and the solar cell strings (11-16), and
the distance (D3) between the second interconnection wiring member and the solar cell strings (11-16) is larger than the distance (D4) between the first interconnection wiring member (21) and the second interconnection wiring member (22).

6. The solar cell module according to any one of claims 1 to 5, wherein the distance (D1) between the solar cells (1) in each of the solar cell strings (11-16) is larger than a width (W) of the interconnection wiring member (21, 22) in the lengthwise direction (X).

## Patentansprüche

1. Solarzellenmodul, das Folgendes umfasst:
Solarzellenstränge (11-16), die nebeneinander in einer Querrichtung angeordnet sind, wobei jeder der Solarzellenstrenge (11-16) Solarzellen (1), die nebeneinander in einer Längsrichtung angeordnet sind, und ein Streifenverdrahtungselement (4), das mindestens einige der Solarzellen (1) miteinander elektrisch verbindet, einschließt;
ein Verbindungsverdrahtungselement (21-27), das mindestens einige der Solarzellenstränge (11-16) miteinander elektrisch verbindet;
ein vorderes Oberflächenelement (7);
ein lichtempfangsseitiges Füllelement (5), das zwischen das vordere Oberflächenelement (7) und die Solarzellenstränge (11-16) gefüllt ist; und
ein hinteres Oberflächenelement (8);
wobei jede der Solarzellen (1) auf ihrer vorderen Oberfläche (1a) eine Sammelschienenelektrode (3) einschließt, die sich in der Längsrichtung erstreckt, und
ein Abstand (D1) zwischen den Solarzellen (1) in jedem der Solarzellenstränge (11-16) größer ist als ein Abstand (D2) zwischen den Solarzellensträngen (11-16),
**dadurch gekennzeichnet, dass** ein reflektierendes Füllelement (6), das aus Harzmaterial gebildet ist, zwischen das hintere Oberflächenelement (8) und die Solarzellenstränge (11-16) gefüllt ist, auf den hinteren Oberflächenseiten der Solarzellenstränge (11-16) bereitgestellt ist und in Kontakt mit der hinteren Oberfläche (1b) der Solarzellen (1) ist und zwischen angrenzenden Solarzellen (1) in jedem der Solarzellenstränge (11-16) und zwischen angrenzenden Solarzellensträngen (11-16) bereitgestellt ist, wobei
eine Höhe des reflektierenden Füllelements zwischen den Solarzellen (1) in jedem der Solarzellenstränge (11-16) größer ist als eine Höhe des reflektierenden Füllelement zwischen den Solarzellensträngen (11-16), sodass ein Abstand (d₁) zwischen dem reflektierenden Füllelement (6) und dem vorderen Oberflächenelement (7) zwischen Solarzellen (1) in jedem der Solarzellenstränge (11-16) kleiner ist als ein Abstand (d₂) zwischen dem reflektierenden Füllelement (6) und dem vorderen Oberflächenelement (7) zwischen den Solarzellensträngen (11-16),
wobei das reflektierende Füllelement (6) zwischen den Solarzellen (1) in jedem der Solarzellenstränge (11-16) auf eine solche Weise bereitgestellt ist, dass es Randteile der vorderen Oberfläche jeder der Solarzellen (1) bedeckt und eine Menge (C), die durch das reflektierende Füllelement zwischen den Solarzellen (1) in jedem der Solarzellenstränge (11-16) bedeckt ist, größer ist als eine Menge, die durch das reflektierende Füllelement zwischen den Solarzellensträngen (11-16) bedeckt ist.

2. Solarzellenmodul gemäß Anspruch 1, wobei das reflektierende Füllelement (6) weiter ein weißes Pigment enthält.

3. Solarzellenmodul gemäß Anspruch 1 oder 2, wobei ein erstes Verbindungsverdrahtungselement (21) und ein zweites Verbindungsverdrahtungselement (22) nebeneinander in der Längsrichtung bereitgestellt sind, wobei das zweite Verbindungsverdrahtungselement (22) näher an einem entsprechenden Solarzellenstrang (12, 13) als das erste Verbindungsverdrahtungselement (21) bereitgestellt ist, wobei der Abstand (D1) zwischen den Solarzellen (1) in jedem der Solarzellensträngen (11-16) größer ist als ein Abstand (D3) zwischen dem zweiten Verbindungsverdrahtungselement (22) und den entsprechenden Solarzellensträngen (12, 13).

4. Solarzellenmodul gemäß einem der Ansprüche 1 bis 3, wobei
als das Verbindungsverdrahtungselement ein erstes Verbindungsverdrahtungselement (21, 22) und ein zweites Verbindungsverdrahtungselement (22, 21) nebeneinander in der Längsrichtung bereitgestellt sind und
der Abstand (D1) zwischen den Solarzellen (1) in jedem der Solarzellenstränge (11-16) größer ist als ein Abstand (D4) zwischen dem ersten Verbindungsverdrahtungselement (21, 22) und dem zweiten Verbindungsverdrahtungselement (22, 21).

5. Solarzellenmodul gemäß Anspruch 4, wobei
das zweite Verbindungsverdrahtungselement (22) näher an den Solarzellensträngen (11-16) als das erste Verbindungsverdrahtungselement bereitgestellt ist,
der Abstand (D1) zwischen den Solarzellen (1) in jedem der Solarzellenstränge (11-16) größer als ein Abstand (D3) zwischen dem zweiten Verbindungsverdrahtungselement (22) und den Solarzellensträngen (11-16) ist und
der Abstand (D3) zwischen dem zweiten Verbindungsverdrahtungselement und den Solarzellensträngen (11-16) größer als der Abstand (D4) zwischen dem ersten Verbindungsverdrahtungselement (21) und dem zweiten Verbindungsverdrahtungselement (22) ist.

6. Solarzellenmodul gemäß einem der Ansprüche 1 bis 5, wobei der Abstand (D1) zwischen den Solarzellen (1) in jedem der Solarzellenstränge (11-16) größer ist als eine Breite (W) des Verbindungsverdrahtungselements (21, 22) in der Längsrichtung (X).

## Revendications

1. Module de cellule solaire comprenant :
des chaînes de cellules solaires (11 à 16) agencées côte à côte dans le sens de la largeur, chacune des chaînes de cellules solaires (11 à 16) comprenant des cellules solaires (1) agencées côte à côte dans le sens de la longueur, et un élément de câblage de languette (4) raccordant électriquement au moins quelques-unes des cellules solaires (1) les unes aux autres ;
un élément de câblage d'interconnexion (21 à 27) raccordant électriquement au moins quelques-unes des chaînes de cellules solaires (11 à 16) les unes aux autres ;
un élément de surface avant (7) ;
un élément de remplissage côté réception de la lumière (5) rempli entre l'élément de surface avant (7) et les chaînes de cellules solaires (11 à 16) ; et
un élément de surface arrière (8) ;
dans lequel chacune des cellules solaires (1) comprend, sur sa surface avant (la), une électrode de barre omnibus (3) s'étendant dans le sens de la longueur et
une distance (D1) entre les cellules solaires (1) dans chacune des chaînes de cellules solaires (11 à 16) est plus importante qu'une distance (D2) entre les chaînes de cellules solaires (11 à 16),
**caractérisé en ce qu'**un élément de remplissage réfléchissant (6) composé d'un matériau de résine est rempli entre l'élément de surface arrière (8) et les chaînes de cellules solaires (11 à 16), disposé sur des côtés de surface arrière des chaînes de cellules solaires (11 à 16) et étant en contact avec la surface arrière (1b) des cellules solaires (1) et disposé entre des cellules solaires (1) adjacentes dans chacune des chaînes de cellules solaires (11 à 16) et entre des chaînes de cellules solaires (11 à 16) adjacentes, dans lequel
une hauteur de l'élément de remplissage réfléchissant entre les cellules solaires (1) dans chacune des chaînes de cellules solaires (11 à 16) est plus importante qu'une hauteur de l'élément de remplissage réfléchissant entre les chaînes de cellules solaires (11 à 16) de telle sorte qu'une distance (d₁) entre l'élément de remplissage réfléchissant (6) et l'élément de surface avant (7) entre des cellules solaires (1) dans chacune des chaînes de cellules solaires (11 à 16) soit plus petite qu'une distance (d₂) entre l'élément de remplissage réfléchissant (6) et l'élément de surface avant (7) entre les chaînes de cellules solaires (11 à 16),
dans lequel l'élément de remplissage réfléchissant (6) est disposé entre les cellules solaires (1) dans chacune des chaînes de cellules solaires (11 à 16) de telle manière à recouvrir des parties périphériques de la surface avant de chacune des cellules solaires (1) et une quantité (C) recouverte par l'élément de remplissage réfléchissant entre les cellules solaires (1) dans chacune des chaînes de cellules solaires (11 à 16) est plus importante qu'une quantité recouverte par l'élément de remplissage réfléchissant entre les chaînes de cellules solaires (11 à 16).

2. Module de cellule solaire selon la revendication 1, dans lequel l'élément de remplissage réfléchissant (6) contient en outre un pigment blanc.

3. Module de cellule solaire selon la revendication 1 ou 2, dans lequel un premier élément de câblage d'interconnexion (21) et un second élément de câblage d'interconnexion (22) sont disposés côte à côte dans le sens de la longueur, dans lequel le second élément de câblage d'interconnexion (22) est disposé plus près d'une chaîne de cellules solaires correspondante (12, 13) que le premier élément de câblage d'interconnexion (21), dans lequel la distance (D1) entre les cellules solaires (1) dans chacune des chaînes de cellules solaires (11 à 16) est plus importante qu'une distance (D3) entre le second élément de câblage d'interconnexion (22) et les chaînes de cellules solaires correspondantes (12, 13).

4. Module de cellule solaire selon l'une quelconque des revendications 1 à 3, dans lequel
en tant qu'élément de câblage d'interconnexion, un premier élément de câblage d'interconnexion (21, 22) et un second élément de câblage d'interconnexion (22, 21) sont disposés côte à côte dans le sens de la longueur, et
la distance (D1) entre les cellules solaires (1) dans chacune des chaînes de cellules solaires (11 à 16) est plus importante qu'une distance (D4) entre le premier élément de câblage d'interconnexion (21, 22) et le second élément de câblage d'interconnexion (22, 21).

5. Module de cellule solaire selon la revendication 4, dans lequel
le second élément de câblage d'interconnexion (22) est disposé plus près des chaînes de cellules solaires (11 à 16) que ne l'est le premier élément de câblage d'interconnexion,
la distance (D1) entre les cellules solaires (1) dans chacune des chaînes de cellules solaires (11 à 16) est plus importante qu'une distance (D3) entre le second élément de câblage d'interconnexion (22) et les chaînes de cellules solaires (11 à 16) et
la distance (D3) entre le second élément de câblage d'interconnexion et les chaînes de cellules solaires (11 à 16) est plus importante que la distance (D4) entre le premier élément de câblage d'interconnexion (21) et le second élément de câblage d'interconnexion (22).

6. Module de cellule solaire selon l'une quelconque des revendications 1 à 5, dans lequel la distance (D1) entre les cellules solaires (1) dans chacune des chaînes de cellules solaires (11 à 16) est plus importante qu'une largeur (W) de l'élément de câblage d'interconnexion (21, 22) dans le sens de la longueur (X).
